# EUROPEAN PATENT SPECIFICATION

(11) **EP 3 499 109 B1**
(45) Date of publication and mention of the grant of the patent: **27.10.2021**
(21) Application number: 17838569.6
(22) Date of filing: 27.07.2017
(51) Int. Cl.: F21S 10/02, F21V 23/00, F21Y 115/10, F21Y 105/10

(54) **LIGHT SOURCE MODULE AND LAMP WITH SAME**
LICHTQUELLENMODUL UND LAMPE DAMIT
MODULE DE SOURCE DE LUMIÈRE ET LAMPE COMPRENANT CE DERNIER

(30) Priority: 09.08.2016 CN 201620856516 U
(43) Date of publication of application: 19.06.2019
(73) Proprietor: Vertex Lighting And Electrical Co., Ltd., Foshan, Guangdong 528000 (CN)
(72) Inventor: WU, Liangju, Foshan Guangdong 528000 (CN)
(74) Representative: Casalonga
(86) International application number: PCT/CN2017/094648
(87) International publication number: WO 2018/028439

(56) References cited:
- WO-A1-2009/109387
- WO-A1-2016/026153
- CN-A- 102 128 396
- CN-A- 104 507 197
- CN-A- 105 698 119
- CN-A- 105 698 119
- CN-U- 201 916 746
- CN-U- 202 302 925
- CN-U- 205 137 334
- CN-U- 205 878 043
- JP-A- 2007 299 590
- JP-A- 2013 004 398

## Description

### BACKGROUND OF THE PRESENT INVENTION

### FIELD OF INVENTION

The present invention relates to a light source module and a lamp with light source module, which emit light source of various colors in an adjustable manner and white lights of various color temperature in an adjustable manner, so as to enhance its diversity and utility.

### DESCRIPTION OF RELATED ARTS

LED has been widely utilized in our daily lives since it is energy efficient and is able to provide lights in various colors. Unfortunately, there are problems for the LED light sources currently available in the market, which include the following. From the perspective of light source, a conventional light source module only has LED chips of the three primary colors. Even though the user may adjust the parameters of the output voltage or current of the power supply to obtain mixed lights of the various proportions of the lights from the red, blue, and green LED chips, in order to achieve a light effect of colors. Nevertheless, such combination light source still has a lot of utilization deficiencies, such as low light efficacy, dissimilar light colors (larger deviations between the light colors emitted from different light sources), and etc.. Therefore, it limits the utilizing of LED light source in scenes like decorative lighting, landscape lighting, and atmosphere lighting only, rather than our daily white light illumination scenes, such as reading, dining, meeting, working, and etc.. Even though there is also dual-color temperature COB light source, it only provide two modes, the cool and warm white lights, which is not enough to satisfy the demands of colors. COB light source module of RGBW four light color output that combine the two has certain drawbacks as well. This type of light source module has LED chips of three primary colors and single white light (which color temperature is 6000K or more). It may achieve mixed white light color through adjusting the parameters of the output voltage and current of the driving power to change the proportion of the luminous intensity of the LED red-green-blue chips and white light chips. Nonetheless, such mixed white light cannot have cool/warm white light with highly consistent light color or natural appearance. Accordingly, this type of LED light source can barely provide ideal white light with adjustable color temperature to satisfy diverse white light illumination scenes.

To analyze from the perspective of packaging technology, it is difficult to produce a RGBW light source module in a four way common anode or common cathode structure, which refers to that the chip set of each light color has two bonding wire pins of the anode and the cathode respectively and, hence, the RGBW light source module contains a total of eight bonding wire pins. Such manner will cause long processing in soldering wires in the lamp assembling process, which can affect the production efficiency of the lamp to a certain extent. Currently, it mainly utilizes reflow soldering technology to solder and attach the discrete parts of LED of the various single colors onto the aluminum PCB, so as to produce a SMD light source module. However, such manufacturing process is too complicated. The production cost is high. Moreover, the size of the SMD light source module is relatively large, so that the size of the lamp has to be correspondingly increased. In addition, because the structure of every discrete parts of LED has to respectively contain a sub-lens, when it conducts secondary light distribution for the multiple luminous points, especially secondary light distribution for the key illumination lamp, it will render optical property defects, such as double image, unnatural light spot transition, layers of different light colors, and etc.. WO 2009/109.387 discloses a light source module.

### SUMMARY OF THE PRESENT INVENTION

An object of the present invention is to provide a light source module and lamp with same, wherein the light source module is capable of performing light of various mixed colors and white light of adjustable color temperature, so as to satisfy demands of diverse scenes.

Another object of the present invention is to provide a light source module and lamp with same, wherein a three-primary-color light source and a set of color temperature adjustable light sources of the light source module are respectively symmetrically arranged on a substrate, wherein a circuit component controls the three-primary-color light source and the color temperature adjustable light sources to emit various lights in a combination manner.

Another object of the present invention is to provide a light source module and lamp with same, wherein the three-primary-color light source and the color temperature adjustable light source share the same anode, wherein the three-primary-color light source and the color temperature adjustable light source respectively have different cathodes, such that the three-primary-color light source and the color temperature adjustable light source can provide and change color temperature respectively based on the strengths of the voltage or current.

Another object of the present invention is to provide a light source module and lamp with same, wherein the color temperature adjustable light source comprises a first color temperature illuminant and a second color temperature illuminant, wherein the first color temperature illuminant and/or the second color temperature illuminant may optionally be matched with the three-primary-color light source and mounted on the substrate.

Another object of the present invention is to provide a light source module and lamp with same, wherein the first color temperature illuminants of the light source module are respectively symmetrically arranged on the two sides of the three-primary-color light source, so as to allow the three-primary-color light source and the first color temperature illuminants to emit light beams of various colors in a combination manner.

Another object of the present invention is to provide a light source module and lamp with same, wherein the second color temperature illuminants of the light source module are respectively symmetrically arranged on the two sides of the three-primary-color light source, so as to allow the three-primary-color light source and the second color temperature illuminants to emit light beams of various colors in a combination manner.

Another object of the present invention is to provide a light source module and lamp with same, wherein the three-primary-color light source, the first color temperature illuminants, and the second color temperature illuminants are respectively symmetrically arranged in the central area of the substrate, wherein the first color temperature illuminants are arranged on the outer side of the three-primary-color light source, wherein the first color temperature illuminants are also located between the three-primary-color light source and the second color temperature illuminants.

Another object of the present invention is to provide a light source module and lamp with same, wherein the three-primary-color light source, the first color temperature illuminants, and the second color temperature illuminants are respectively symmetrically arranged on the substrate, wherein the second color temperature illuminants are arranged on the outer side of the three-primary-color light source, wherein the second color temperature illuminants are also located between the three-primary-color light source and the first color temperature illuminants.

Another object of the present invention is to provide a light source module and lamp with same, wherein the first color temperature illuminant and/or the second color temperature illuminant are respectively arranged on the substrate concentrically to the center of the three-primary-color light source, so as to respectively become a periphery of the three-primary-color light source.

Another object of the present invention is to provide a light source module and lamp with same, wherein the three-primary-color light source, the first color temperature illuminants, and the second color temperature illuminants share the same anode, wherein the three-primary-color light source, the first color temperature illuminants, and the second color temperature illuminants respectively have different cathodes, such that the three-primary-color light source, the first color temperature illuminants, and the second color temperature illuminants can provide and change color temperature respectively based on the strengths of the voltage or current.

Another object of the present invention is to provide a light source module and lamp with same, wherein the three-primary-color light source comprises a set of first chips and a first cover layer, wherein the first chips are longitudinally arranged and aligned along an A axis on the substrate, so as for adjustably emitting various three-primary-color lights.

Another object of the present invention is to provide a light source module and lamp with same, wherein the first color temperature illuminant comprises a set of second chips and a second cover layer, wherein the second chips are longitudinally arranged and aligned along the A axis, wherein the second cover layer covers the second chips, so as to allow the second chips to generate adjustable cool white light.

Another object of the present invention is to provide a light source module and lamp with same, wherein the second color temperature illuminants comprises a set of third chips and a third cover layer, wherein the third chips are longitudinally arranged and aligned along the A axis, wherein the third cover layer covers the third chips, so as to allow the third chips to generate adjustable warm white light.

Another object of the present invention is to provide a light source module and lamp with same, wherein the light-emitting sources share a lens, so as for achieving a secondary light distribution design and providing a spotlighting effect in a certain light angle.

Another object of the present invention is to provide a light source module and lamp with same, wherein the light-emitting sources are symmetrically arranged on the substrate based on a predetermined rule, so as to achieve a compact structure.

Another object of the present invention is to provide a light source module and lamp with same, wherein the light source module made through chip level packaging chip on board (COB) technology is advantageous in small size, so as to allow the light source module to have a compact structure.

Another object of the present invention is to provide a light source module and lamp with same, wherein the light source module is a COB light source module manufactured by LED packaging manufacturer, which reduces producing steps and saves production costs.

Another object of the present invention is to provide a light source module and lamp with same, wherein the lamp comprises a shell and a connecting member, wherein the shell further comprises a base, a housing, and a face cover, wherein the base, the housing, and the face cover are detachably connected through the connecting member respectively.

Another object of the present invention is to provide a light source module and lamp with same, wherein the light source module is detachably arranged in an accommodating chamber of the base through a heat dissipation member, wherein a lens is also arranged on the light source module.

A technical solution of the present invention that achieves at least is provided by light source module according to independent claim 1. The dependent claims relate to advantageous embodiments.

### BRIEF DESCRIPTION OF THE DRAWINGS

Figs. 1A and 1B illustrate positional relations of the three-primary-color light source and the first color temperature illuminants arranged on the substrate according to a first embodiment of the present invention.
Figs. 2A and 2B illustrate positional relations of the three-primary-color light source and the second color temperature illuminants arranged on the substrate according to a second embodiment of the present invention.
Figs. 3A and 3B illustrate positional relations of the three-primary-color light source, the first color temperature illuminants, and the second color temperature illuminants arranged on the substrate according to a third embodiment of the present invention.
Figs. 4A and 4B illustrate positional relations of the three-primary-color light source, the first color temperature illuminants, and the second color temperature illuminants arranged on the substrate according to a fourth embodiment of the present invention.
Figs. 5A and 5B illustrate positional relations of the three-primary-color light source, the first color temperature illuminants, and the second color temperature illuminants arranged on the substrate according to an embodiment not covered by claim 1 and according to a fifth embodiment of the present invention respectively.
FIG. 6 is a circuit schematic illustrating the first chips, the second chips, and the third chips arranged on the substrate according to the present invention.
Fig. 7 is a perspective view of a lamp with light source module according to the present invention.
Fig. 8 is an exploded view of a lamp with light source module according to the present invention.

### DETAILED DESCRIPTION OF THE PREFERRED EMBODIMENT

The following description is disclosed to enable any person skilled in the art to make and use the present invention. Preferred embodiments are provided in the following description only as examples and modifications will be apparent to those skilled in the art. The general principles defined in the following description would be applied to other embodiments, alternatives, modifications, equivalents, and applications without departing from the scope of the present invention.

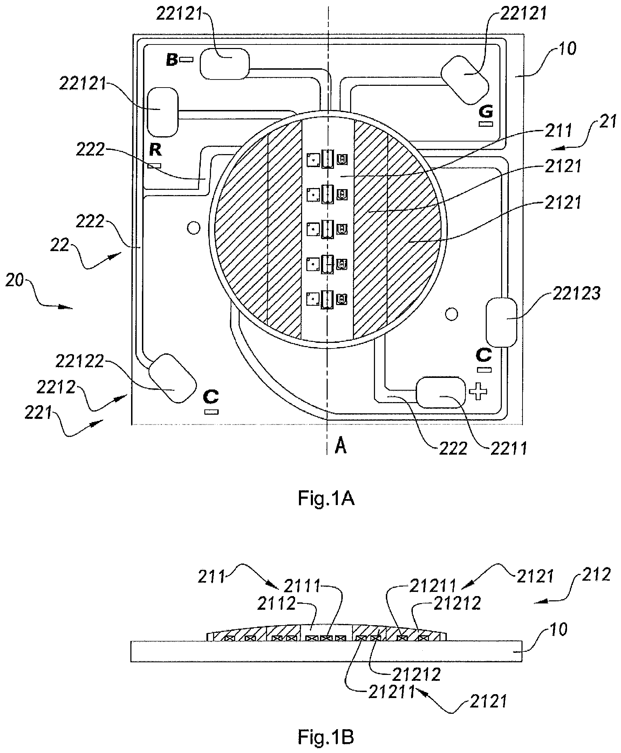

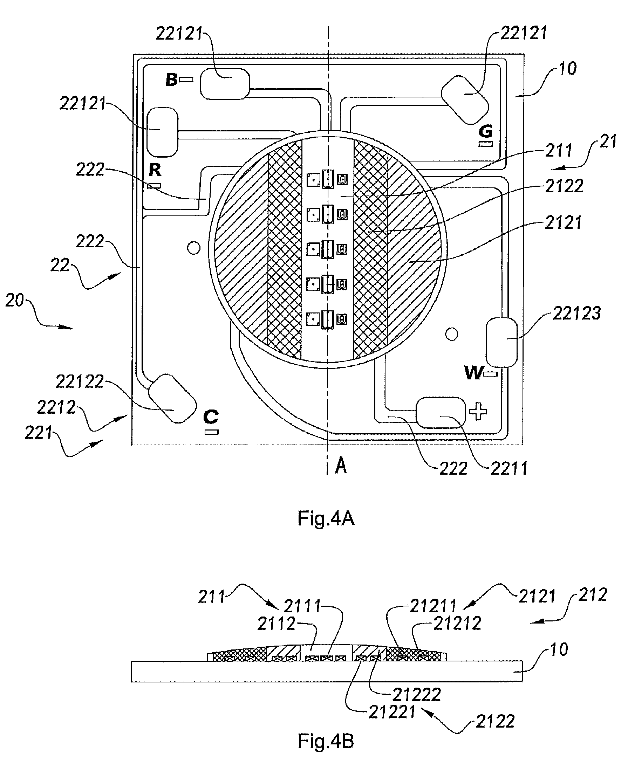

Referring to Figs. 1A-4B, a light source module 1 of the present invention is capable of providing lights of various adjustable colors and white lights in various adjustable color temperature. Therefore, the light source module 1 may be widely utilized in different daily circumstances, while conventional light source module can be much limited in use. The light source module 1 comprises a substrate 10 and a light source assembly 20 arranged in a central area on a mounting side of the substrate 10. The substrate 10 provides a mounting surface for the light source module 1. The substrate 10 is a sheet structure made of aluminum or ceramics.

The light source assembly 20 comprises a light-emitting source 21 and a circuit component 22. The light-emitting source 21 and the circuit component 22 are respectively arranged on the mounting side of the substrate 10. The light-emitting source 21 is electrically connected with an external power supply through the circuit component 22, such that the light-emitting source 21 can generate light when powered on. The light source module 1 may produce different light combination based on the needs of the user. It emits various types of color light beams by combining different proportions of brightness of the three primary color lights or high luminous efficient white lights with various color temperatures by combining different proportions of brightness of cool and/or warm white lights. It is worth mentioning that the light-emitting source 21 further comprises a three-primary-color light source 211 and at least a color temperature adjustable light source 212, wherein the three-primary-color light source 211 and the color temperature adjustable light source 212 are respectively arranged on the substrate 10, wherein the three-primary-color light source 211 and the color temperature adjustable light source 212 are respectively electrically connected with the circuit component 22. Besides, an external power supply is electrically connected with the circuit component 22, so as to power on the three-primary-color light source 211 and the color temperature adjustable light source 212. Lights emitted by the three-primary-color light source 211 and the color temperature adjustable light source 212 may have various colors in a selective combination manner, so as for satisfying diverse demands. Here, the three-primary-color light source 211 is a chip with three primary color wave bands. The light source of three primary color wave bands, based on the understanding of person skilled in the art, refers to that the three-primary-color light source 211 is capable of emitting red light, blue light, and green light. In actual use, the light source of three primary color wave bands utilizes the three primary colors as a basis and selects different brightness proportionally to be mixed or combined into various colors. In other words, the three-primary-color light source 211 may, based on the actual needs of the user, be freely adjusted and changed to produce light beams of various colors, so as to satisfy the needs of the utilization.

Here, the color temperature adjustable light source 212 comprises a set of first color temperature illuminants 2121 and a set of second color temperature illuminants 2122. The first color temperature illuminants 2121 being powered on may generate cool white light, while the second color temperature illuminants 2122 being powered on may generate warm white light. Also, the first color temperature illuminants 2121 and the second color temperature illuminants 2122 emit high luminous efficient white lights with various color temperatures by combining different proportions of brightness of white lights, so as to satisfy the needs of various circumstances. Contrasting to conventional light source module, the light source module 1 can selectively adjust the proportion of the combination of the three-primary-color light sources and/or the cool/warm white lights, so as to provide an enhanced utility. Light source module currently available in the market can only utilize either the three-primary-color light source or the color temperature adjustable light source. Even if both of the light sources are utilized at the same time, the mixed white light fails to be natural or present cool/warm white light with highly consistent light color. Accordingly, such kind of light source can barely provide ideal white light with adjustable color temperature to satisfy diverse white light illumination scenes.

It is worth mentioning that the three-primary-color light source 211 comprises a set of first chips 2111 and a first cover layer 2112. The first chips 2111 are arranged in the central area of the substrate 10 and longitudinally aligned along a A axis in a regular manner, wherein the red light chips, the blue light chips, and the green light chips are respectively arranged based on a certain rule. Here, to be along the A axis may be considered the y-axis direction, while to be perpendicular to the A axis may be considered the x-axis direction. The red light chips, the blue light chips, and the green light chips are respectively, successively, and longitudinally arranged along the A axis. For each row in the x-axis direction, the red light chips, the blue light chips, and the green light chip are arranged and aligned in accordance with a certain predetermined space. The first cover layer 2112 is correspondingly longitudinally arranged along the A axis to cover the surface of the first chips 2111. The first cover layer 2112 is a clear colloid, which material is a transparent colloid, such as silicone or epoxy resin. The first chips 2111 covered by the first cover layer 2112 may emit three-primary-color lights.

The first color temperature illuminant 2121 comprises a set of second chips 21211 and a second cover layer 21212 covered on the second chips 21211. When the second chips 21211 are provided on the substrate 10, the second cover layer 21212 correspondingly longitudinally covers the surface of the second chips 21211 along the A axis. The second chips 21211, under the covering of the second cover layer 21212, are capable of performing as the first color temperature illuminants 2121 to produce and emit cool white color light in the color temperature of 4000K-8000K or, preferably, 4500K-7000K. The second chips 21211 are longitudinally arranged and aligned along the A axis based on a certain rule, wherein a predetermined distance is kept between each two second chips 21211. Here, the second cover layer 21212 is a colloid with ingredient of YAG phosphor.

The second color temperature illuminant 2122 comprises a set of third chips 21221 and a third cover layer 21222 correspondingly longitudinally covered on the third chips 21221 along the A axis. When the third chips 21221 are provided on the substrate 10, the surface of the third chips 21221 are covered by the third cover layer 21222. The third chips 21221, under the covering of the third cover layer 21222, are capable of performing as the second color temperature illuminants 2122 to produce and emit warm white color light in the color temperature of 1000K-4500K or, preferably, 2000K-3500K. The third chips 21221 are longitudinally arranged and aligned along the A axis based on a certain rule, wherein a predetermined distance is kept between each two third chips 21221. Here, the third cover layer 21222 is a colloid with ingredient of YAG phosphor.

It is worth mentioning that the first chip 2111 is a three primary color LED chip, the second chip 21211 is a cool white light LED chip (high efficiency InGaN/GaN based LED blue light chip), and the third chip 21221 is a warm white light LED chip (high efficiency InGaN/GaN based LED blue light chip). The LED blue light chip being powered on can emit light to stimulate the ingredient of YAG phosphor of various proportions in the colloid of the cover layer for producing white light in various color temperatures. Here, when the second chips 21211 are powered on to emit light, the YAG phosphor in the second cover layer 21212 will be stimulated to produce cool white light in the color temperature of 4500K-7000K. Similarly, when the third chips 21221 are powered on to emit light, the YAG phosphor in the third cover layer 21222 will be stimulated to produce warm white light in the color temperature of 1000K- 4000K. The white light in the color temperature of 1000K-7000K can be emitted in a combination manner through adjusting the setting of the numerical ratio of the voltage or current of the second chips 21211 and the third chips 21221 and correspondingly through the second cover layer 21212 and the third cover layer 21222, such that the light source module 1 can achieve a white light illuminating effect with adjustable color temperature.

It is worth mentioning that the electric connection among the first chips 2111, the second chips 21211, and the third chips 21221 can be achieved through related semiconductor packaging technologies. The first chips 2111 are electrically connected with each other in series; the second chips 21211 are electrically connected with each other in series; and the third chips 21221 are electrically connected with each other in series. The first chips 2111, the second chips 21211, and the third chips 21221 are electrically connected with one another in series as well.

It is worth mentioning that there are four ways of the arrangements among the first chips 2111, the second chips 21211, and the third chips 21221. According to a first embodiment as illustrated in Figs. 1A and 1B, the first chips 2111 are arranged and aligned perpendicularly along the A axis on the substrate 10, while the second chips 21211 are respectively arranged and aligned by the two sides of the first chips 2111 and along the A axis as well. Besides, the second chips 2121 are arranged and aligned perpendicularly along the A axis. In addition, the arranging directions of the first chips 2111 and the second chips 21211 are consistent. Here the first chips 2111 and the second chips 21211 are parallel to each other. The users may, based on their needs, adjust the brightness of the first chips 2111 and the second chips 21211 in order to selectively generate light beams of various colors in a combination manner. Namely, the three-primary-color light source 211 and the first color temperature illuminants 2121 may produce light source of various colors in a combination manner.

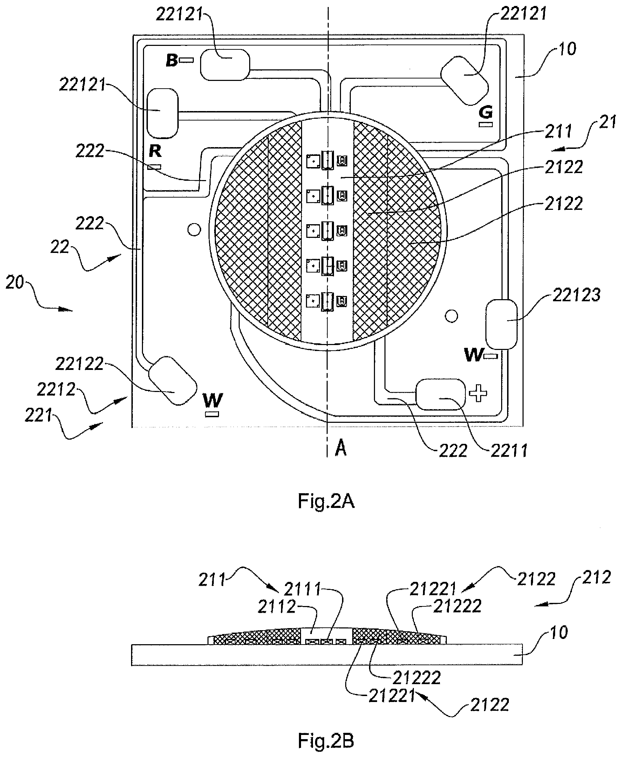

According to a second embodiment as illustrated in Figs. 2A and 2B, the first chips 2111 are arranged and aligned perpendicularly along the A axis on the substrate 10, while the third chips 21221 are respectively arranged and aligned by the two sides of the first chips 2111 and along the A axis as well. Besides, the third chips 21221 are arranged and aligned perpendicularly along the A axis. In addition, the arranging directions of the first chips 2111 and the third chips 21221 are consistent. Here the first chips 2111 and the third chips 21221 are parallel to each other. The users may, based on their needs, adjust the brightness of the first chips 2111 and the third chips 21221 in order to selectively generate light beams of various colors in a combination manner. Namely, the three-primary-color light source 211 and the second color temperature illuminants 2122 may produce light source of various colors in a combination manner.

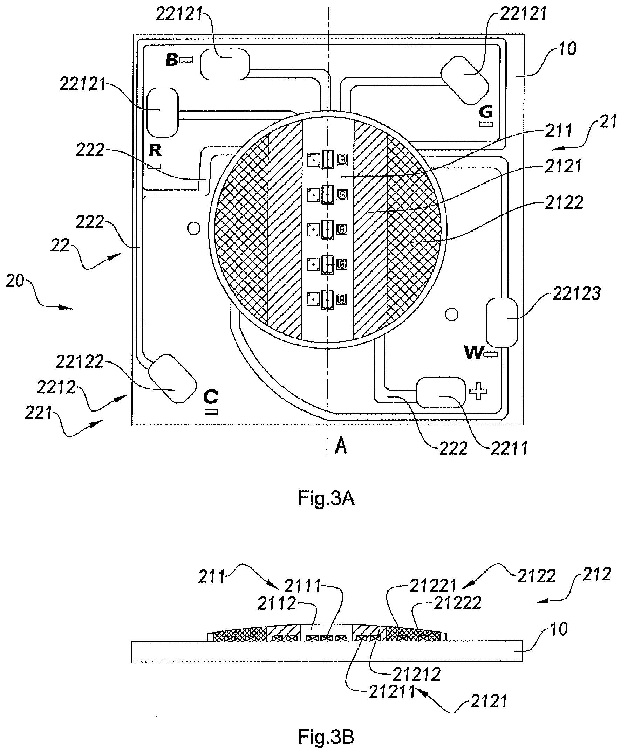

According to a third embodiment as illustrated in Figs. 3A and 3B, the first chips 2111 are arranged and aligned perpendicularly along the A axis on the substrate 10, while the second chips 21211 are respectively arranged and aligned by the two sides of the first chips 2111 and along the A axis as well. Besides, the third chips 21221 are respectively arranged by the periphery of the second chips 21211, which can be considered that the third chips are arranged adjacent to the edge of the substrate 10. In addition, the arranging directions of the first chips 2111, the second chips 21211, and the third chips 21221 are consistent. In other words, the second chips 21211 are respectively located between the first chips 2111 and the third chips 21221. Here, the first chips 2111, the second chips 21211, and the third chips 21221 are respectively parallel to one another. The user may, based on the needs, adjust the brightness of the first chips 2111, the second chips 21211, and the third chips 21221, so as to selectively produce light beam of various colors in a combination manner. Namely, light of various colors can be generated through combining different light sources of the three-primary-color light source 211, the first color temperature illuminants 2121, and the second color temperature illuminants 2122.

It is worth mentioning that because the first chips 2111, the second chips, and the third chips 21221 are respectively longitudinally arranged into straight lines, when covering and coating corresponding clear packaging colloid on the positions of the first chips 2111, the second chips, and the third chips 21221, the glue dispensing processes can also be simplified into straight back and forth movements, which enhances the production efficiency of the light source module 1 to a certain extent.

According to a fourth embodiment as illustrated in Figs. 4A and 4B, the first chips 2111 are arranged and aligned perpendicularly along the A axis on the substrate 10, while the third chips 21221 are respectively arranged and aligned by the two sides of the first chips 2111 and along the A axis as well. Besides, the second chips 21211 are respectively arranged by the periphery of the third chips 21211, which can be considered that the third chips are arranged adjacent to the edge of the substrate 10. In addition, the arranging directions of the first chips 2111, the third chips 21221, and the third chips 21221 are consistent. In other words, the third chips 21221 are respectively located between the first chips 2111 and the second chips 21211. Here, the first chips 2111, the second chips 21211, and the third chips 21221 are respectively parallel to one another. The user may, based on the needs, adjust the brightness of the first chips 2111, the second chips 21211, and the third chips 21221, so as to selectively produce light beam of various colors in a combination manner. Namely, light of various colors can be generated through combining different light sources of the three-primary-color light source 211, the first color temperature illuminants 2121, and the second color temperature illuminants 2122.

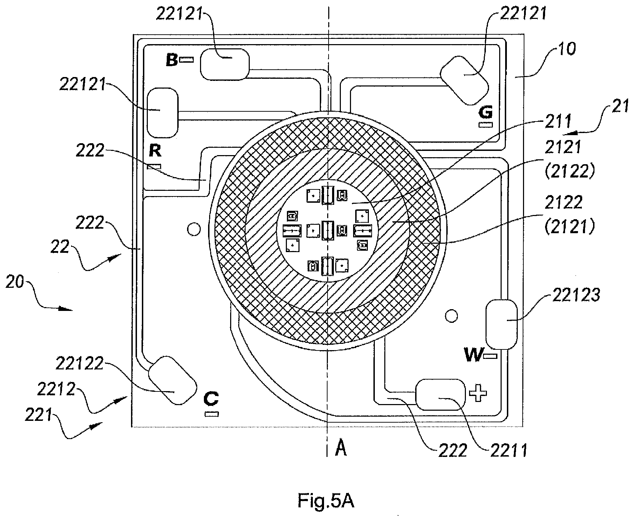

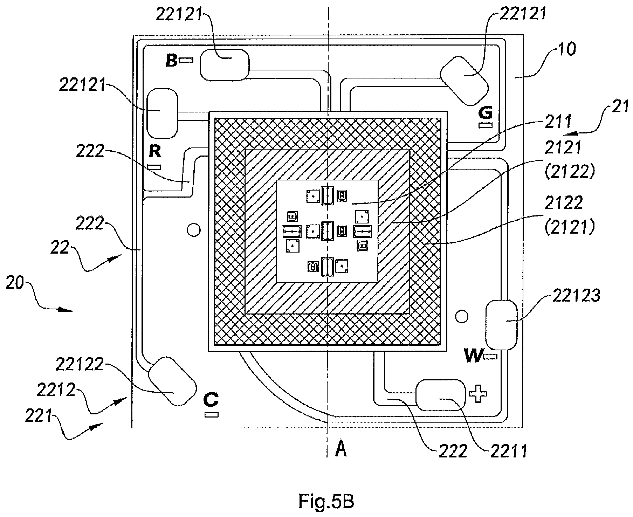

According to an embodiment of the present disclosure not covered by claim 1 and according to a fifth embodiment of the present invention, as illustrated in Figs. 5A and 5E respectively , the first chips 2111 are positioned in the central area of the substrate 10 and the second chips 21211 and the third chips 21221 are arranged according to the same central point of the pattern formed by the first chips 2111. Referring to Fig. 5A, the second chips 21211 and/or the third chips 21221 are respectively arranged by the periphery of the first chips 2111. Namely, the second chips 21211 are positioned by the periphery of the first chips 2111 or the third chips 21221 are positioned by the periphery of the first chips 2111 or both the second chips 21211 and the third chips 21221 are respectively positioned by the periphery of the first chips 2111. The first color temperature illuminants 2121 and/or the second color temperature illuminants 2122 are respectively positioned around the three-primary-color light source 211 in a ring-like or girdle manner. The first chips 2111 form a circular shape, while the second chips 21211 and the third chips 21221 respectively form a ring shape. Referring to Fig. 5B, the first chips 2111 form a square shape, while the second chips 21211 and the third chips 21221 respectively form a square ring-like shape.

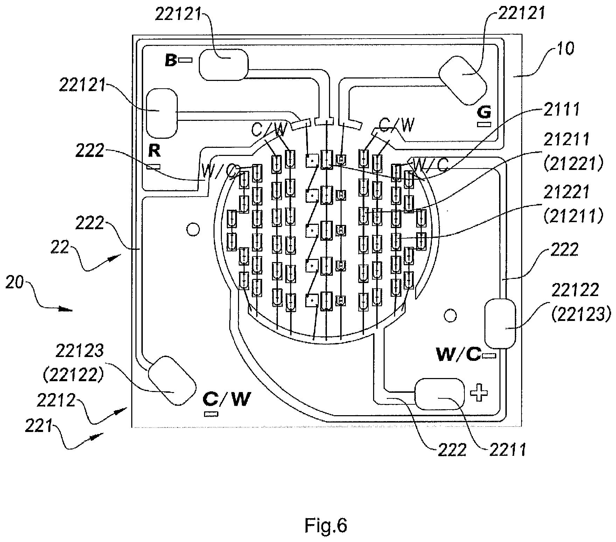

Here, according to a third embodiment and a fourth embodiment, as illustrated in Fig. 6, the circuit components 22 are respectively electrically connected with the three-primary-color light source 211, the first color temperature illuminants 2121, and the second color temperature illuminants 2122. After an external power supply is connected to the circuit components 22, the light-emitting source 21 may emit light. Besides, it may also correspondingly adjust the strength of the currents and voltages of the three-primary-color light source 211, the first color temperature illuminants 2121, and the second color temperature illuminants 2122 of based on the needs, so as to change the intensity of the light emitted from the three-primary-color light source 211, the first color temperature illuminants 2121, and the second color temperature illuminants 2122. The circuit component 22 comprises an electrode member 221 and an electric connection member 222. The electrode member 221 is electrically connected with the electric connection member 222. The electrode member 221 is adapted for connecting with an external power supply. The first chips 2111, the second chips 21211, and the third chips 21221 are all electrically connected through the electric connection member 222. An external power supply is connected with the electrode member 221 to power on the light-emitting source 21 through the electric connection member 222 and allow the light-emitting source 21 to emit light.

Here, according to a first embodiment, the circuit components 22 are respectively electrically connected with the three-primary-color light source 211 and the first color temperature illuminants 2121. After the external power supply is connected to the circuit components 22, the light-emitting source 21 may emit light. Besides, it may also correspondingly adjust the strength of the currents and voltages of the three-primary-color light source 211 and the first color temperature illuminants 2121 based on the needs, so as to change the intensity of the light emitted from the three-primary-color light source 211 and the first color temperature illuminants 2121. The circuit component 22 comprises an electrode member 221 and an electric connection member 222. The electrode member 221 is electrically connected with the electric connection member 222. The electrode member 221 is adapted for connecting with the external power supply. The first chips 2111 and the second chips 21211 are electrically connected through the electric connection member 222. The external power supply is connected with the electrode member 221 to power on the three-primary-color light source 211 and the first color temperature illuminants 2121 through the electric connection member 222 to emit light.

Here according to a second embodiment, the circuit components 22 are respectively electrically connected with the three-primary-color light source 211 and the second color temperature illuminants 2122. After the external power supply is connected to the circuit components 22, the light-emitting source 21 may emit light. Besides, it may also correspondingly adjust the strength of the currents and voltages of the three-primary-color light source 211 and the second color temperature illuminants 2122 based on the needs, so as to change the intensity of the light emitted from the three-primary-color light source 211 and the second color temperature illuminants 2122. The circuit component 22 comprises an electrode member 221 and an electric connection member 222. The electrode member 221 is electrically connected with the electric connection member 222. The electrode member 221 is adapted for connecting with an external power supply. The first chips 2111 and the third chips 21221 are electrically connected through the electric connection member 222. The external power supply is connected with the electrode member 221 to power on the three-primary-color light source 211 and the second color temperature illuminants 2122 through the electric connection member 222 to emit light.

It is worth mentioning that the electrode member 221 comprises an anode 2211 and a set of cathodes 2212. The anode 2211 is for electrically connecting with the anode of an external power supply, while the cathodes 2212 are for electrically connecting with the cathode of the external power supply. A feature of the present invention is that the light-emitting sources 21 share one anode, such that it can reduce the arrangement of the anode 2211 on the substrate 10, so as to reduce manufacturing step, reduce mounting, welding, and soldering process, and saving power and materials like wire and etc.. The cathode 2212 further comprises a first cathode 22121, a second cathode 22122, and a third cathode 22123. The first cathode 22121 is electrically connected with the three-primary-color light source 211, the second cathode 22122 is electrically connected with the first color temperature illuminant 2121, and the third cathode 22123 is electrically connected with the second color temperature illuminant 2122. The working condition of the illumination module 1 includes electrically connecting the anode of the external power supply with the anode 2211 and electrically connecting the cathode of the external power supply with the first cathode 22121, the second cathode 22122, and the third cathode 22123 respectively, so as to set the illumination module 1 in a power on condition to turn the illumination module 1 into an illuminated and active status. It may respectively adjust the voltage strength of the three-primary-color light source 211, the first color temperature illuminants 2121, and the second color temperature illuminants 2122 to drive the light-emitting source 21 to change in color and brightness based on the actual needs of the user. It is worth mentioning that the first cathode 22121 has three cathode points, respectively electrically connected with the red light chip, the blue light chip, and the green light chip. One ends of the first chips 2111, the second chips 21211, and the third chips 21221 are mutually electrically connected with the anode 2211, while the other ends of the first chips 2111, the second chips 21211, and the third chips 21221 are respectively electrically connected with the cathodes 2212, wherein the anode 2211 is electrically connected with the anode of the external power supply, while the cathodes 2212 are electrically connected with the cathode of the external power supply.

Here, according to the above first embodiment, the first cathode 22121 is electrically connected with the three-primary-color light source 211 and the second cathode 22122 is electrically connected with the first color temperature illuminants 2121. The working condition of the illumination module 1 includes electrically connecting the anode of the external power supply with the anode 2211 and electrically connecting the cathode of the external power supply with the first cathode 22121 and the second cathode 22122 respectively, so as to set the illumination module 1 in a power on condition to turn the illumination module 1 into an illuminated and active status. It may respectively adjust the voltage strength of the three-primary-color light source 211 and the first color temperature illuminants 2121 to drive the light-emitting source 21 to change in color and brightness based on the actual needs of the user. It is worth mentioning that the first cathode 22121 has three cathode points, respectively electrically connected with the red light chip, the blue light chip, and the green light chip. One ends of the first chips 2111 and the second chips 21211 are mutually electrically connected with the anode 2211, while the other ends of the first chips 2111 and the second chips 21211 are respectively electrically connected with the cathodes 2212, wherein the anode 2211 is electrically connected with the anode of the external power supply, while the cathodes 2212 are electrically connected with the cathode of the external power supply.

Here, according to the above second embodiment, the first cathode 22121 is electrically connected with the three-primary-color light source 211 and the third cathode 22123 is electrically connected with the second color temperature illuminants 2122. The working condition of the illumination module 1 includes electrically connecting the anode of the external power supply with the anode 2211 and electrically connecting the cathode of the external power supply with the first cathode 22121 and the third cathode 22123 respectively, so as to set the illumination module 1 in a power on condition to turn the illumination module 1 into an illuminated and active status. It may respectively adjust the voltage strength of the three-primary-color light source 211 and the second color temperature illuminants 2122 to drive the light-emitting source 21 to change in color and brightness based on the actual needs of the user. It is worth mentioning that the first cathode 22121 has three cathode points, respectively electrically connected with the red light chip, the blue light chip, and the green light chip. One ends of the first chips 21221 and the third chips 2111 are mutually electrically connected with the anode 2211, while the other ends of the first chips 2111 and the third chips 21221 are respectively electrically connected with the cathodes 2212, wherein the anode 2211 is electrically connected with the anode of the external power supply, while the cathodes 2212 are electrically connected with the cathode of the external power supply.

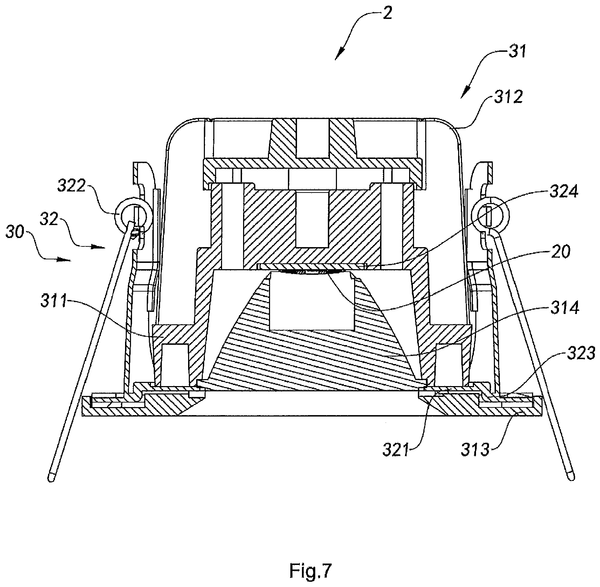

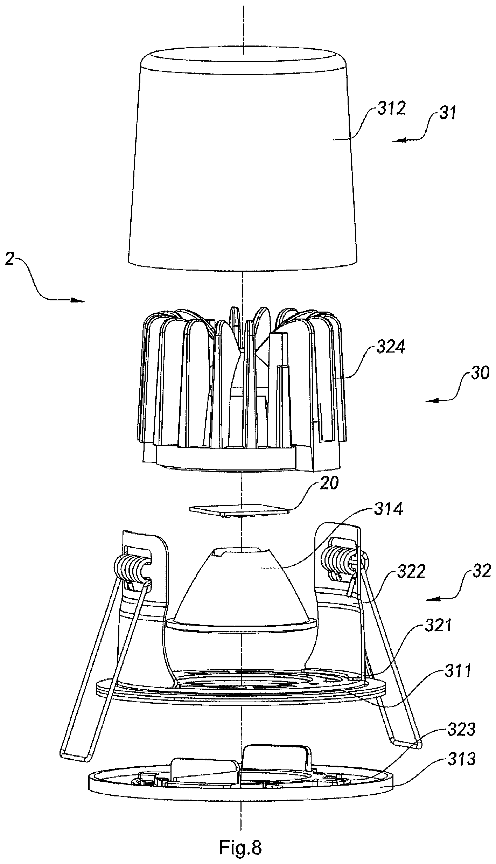

Referring to Figs. 7 and 8, the present invention also relates to a lamp 2 that has a light source module. The lamp can be a daily lamp, such as desk lamp, working light, fancy lamp, and etc., as long as the light-emitting source of the daily lamp has been replaced by the light source module 1 of the present invention. Preferably, the lamp is a ceiling lamp to be mounted on a setting surface, such as ceiling and etc.. A ceiling lamp is advantageous in hidden installation, compact installation space, and etc., which has widely utilized in our daily life. The lamp 2 with light source module comprises a lamp body 30 and a light source module 20 arranged on the lamp body 30, which allows the lamp 30 to emit various types of color light beams by combining different proportions of brightness of the three primary color lights or high luminous efficient white lights with various color temperatures by combining different proportions of brightness of cool and/or warm white lights. Accordingly, the lamp 2 with light source module can be widely utilized in various circumstances to satisfy the needs of the users.

Here, the lamp body 30 comprises a shell 31 and a connecting element 32, while the shell 31 and the light source module 20 are connected respectively through the connecting element 32. The shell 31 comprises a base 311 and a housing 312. The base 311 is detachably mounted on the housing 312. The connecting element 32 comprises a first connecting member 321 and a set of mounting members 322. The base 311 is detachably connected with the housing 31 through the first connecting member 321. The mounting members 322 are respectively symmetrically arranged on the two sides of the housing. The lamp body 30 is arranged on a mounting surface through the mounting members 322. Preferably, the mounting members 322 are resilient hanging elements.

It is worth mentioning that the shell 31 further comprises a face cover 313. The connecting element 32 further comprises a second connecting member 323. The face cover 313 is detachably connected with the base 311 through the second connecting member 323. The face cover 313 has a transparent side arranged in the middle thereof. The light beam emitted by the light source module 20 passes through the transparent side to be projected out.

It is worth mentioning that the shell 31 further comprises a lens 314 and a heat dissipation member 324 respectively arranged in the chamber of the housing 312. The light source module 20 is attached on the heat dissipation member 324. The light beam generated by the light source module 20 under the power-on state will be projected out through the lens 314. Here, the lens 314 serves to condense and guide the light emitted by the light source module 1. The light source module 1 is arranged in the inner side of the lens 314. Contrasting to conventional art, the light source module 1 sharingly utilizes only one lens 314, so as to achieve a spotlighting effect in a predetermined light angle. The predetermined light angle is usually 10°-60°. Accordingly, it also brings advantages, such as making the color of the combined and mixed light emitted by the light source module 1 even and natural, making the transitions of the light spots natural, avoid noise colors, and etc..

It is worth mentioning that the light source modules 1 according to the above four embodiments may respectively be mounted in an accommodating chamber of the lamp body 31 based on the needs, so as to satisfy various user demands.

One skilled in the art will understand that the embodiment of the present invention as shown in the drawings and described above is exemplary only and not intended to be limiting.

Objectives of the present invention are completely and effectively implemented. Notions of the functions and structures of the present invention have been shown and described in the embodiments, whereas implementations of the present invention may have modifications or changes in any ways without going against the above notions.

## Claims

1. A light source module (1), comprising:
a substrate (10); and
a light source assembly, comprising a light-emitting source (21) provided on said substrate (10), wherein said light-emitting source further comprises:
a three-primary-color light source (211), arranged on said substrate (10), and
at least a color temperature adjustable light source (212), respectively arranged on said substrate (10) and on the exterior of said three-primary-color light source (211), so as to allow said three-primary-color light source (211) and said color temperature adjustable light source (212) to emit various light sources (212) in a combination manner,
wherein said color temperature adjustable light source (212) comprises a set of first color temperature illuminants (2121) and a set of second color temperature illuminants (2122), wherein said first color temperature illuminants (2121) are respectively arranged on the two sides of said three-primary-color light source (211), wherein said second color temperature illuminants (2122) are arranged by the outer side of said first color temperature illuminant (2121), such that said first color temperature illuminants are located between said three-primary-color light source and said second color temperature illuminants,
said three-primary-color light source (211) comprises a set of first chips (2111) and a first cover layer (2112), wherein said first chips are longitudinally arranged and aligned along an A axis on said substrate (10), wherein said first cover layer (2112) correspondingly longitudinally covers the surface of said first chips (2111) along said A axis,
said first color temperature illuminant (2121) comprises a set of second chips (21211) and a second cover layer (21212), wherein said second chips are longitudinally arranged and aligned along said A axis, wherein said second cover layer (21212) correspondingly longitudinally covers the surface of said second chips (21211) along said A axis,
said second color temperature illuminant (2122) comprises a set of third chips (21221) and a third cover layer, wherein said third chips (21221) are longitudinally arranged and aligned along said A axis, wherein said third cover layer correspondingly longitudinally covers the surface of said third chips (21221) along said A axis,
said second chips (21211) are respectively arranged by the two sides of said first chips (2111), wherein said third chips (21221) are arranged by the outer side of said second chips (21211), such that said second chips are located between said first chips (2111) and said third chips (21221),
said light source assembly (20) comprises a circuit component (22), arranged on said substrate (10), wherein said three-primary-color light source (211) and said color temperature adjustable light source (212) are respectively electrically connected with said circuit component (22), wherein an external power supply is electrically connected with said light-emitting source (21) through said circuit component (22), so as to allow said light-emitting source (21) to emit various colors of light in a combination manner based on predetermined demand,
said circuit component (22) comprises an electrode member and an electric connection member, wherein said electrode member and said electric connection member are respectively electrically connected with said first chips (211 1), said second chips (21211), and said third chips (21221), wherein the external power supply, through said electrode member and said electric connection member, allows said three-primary-color light source (211), said first color temperature illuminants (2121), and said second color temperature illuminants (2122) to be in an active status for emitting light,
said electrode member further comprises an anode (2211) and a set of cathodes (2212), wherein one ends of said first chips (2111), said second chips (21211), and said third chips (21221) are mutually electrically connected with said anode (2211), while the other ends of said first chips (2111), said second chips (21211), and said third chips (21221) are respectively electrically connected with said cathodes (2212), wherein said anode (2211) is electrically connected with the anode (2211) of the external power supply, while said cathodes (2212) are electrically connected with the cathode of the external power supply,
said first chip is a three primary color LED chip, which comprises a three way chipset of a red light chip, a blue light chip, and a green light chip respectively, wherein said first cover layer (2112) is a transparent colloid of silicone or epoxy resin, so as to allow lights of various colors to be emitted in a combination manner through said first cover layer (2112) by adjusting and configuring the numerical ratio of the voltage and the current of the three way chipset of the three primary color LED chip,
said second chip and said third chip are both blue light LED chips, wherein said second cover layer (21212) is a colloid with ingredient of YAG phosphor of a specific proportion, so as to allow said second chips (21211) to emit cool white color light in the color temperature of 4500K-7000K through said second cover layer (21212), while said third cover layer is a colloid with ingredient of YAG phosphor of another specific proportion, so as to allow said third chips (21221) to emit warm white color light in the color temperature of 1000K-4500K through said third cover layer, such that said light source module (1) is allowed to emit white light in the color temperature of 1000K-7000K in a combination manner through said second cover layer (21212) and said third cover layer respectively and correspondingly, so as to be color temperature adjustable in white light illumination.

2. A lamp (2) with a light source module (1), comprising: a lamp body (30); and
a light source module (1) according to claim 1, wherein said light source module is arranged in an accommodating chamber of said lamp body, wherein said light source module emits light of various colors in a combination manner through adjusting or changing the numeric values of the voltage or current of the external power supply.

3. The lamp (2) with a light source module (1), as recited in claim 2, wherein said lamp body (30) comprises a shell (31), wherein said shell (31) comprises a housing (312) and a lens (314) arranged on said housing (312), wherein the light beam of said light source module is emitted through said lens (314).

## Patentansprüche

1. Lichtquellenmodul (1), aufweisend:
ein Substrat (10); und
eine Lichtquellenanordnung, die eine lichtemittierende Quelle (21) aufweist, die auf dem Substrat (10) vorgesehen ist, wobei die lichtemittierende Quelle ferner aufweist:
eine Lichtquelle (211) mit drei Primärfarben, die auf dem Substrat (10) angeordnet ist, und
mindestens eine Lichtquelle (212) mit einstellbarer Farbtemperatur, die auf dem Substrat (10) bzw. auf der Außenseite der Lichtquelle (211) mit drei Primärfarben angeordnet ist, so dass die Lichtquelle (211) mit drei Primärfarben und die Lichtquelle (212) mit einstellbarer Farbtemperatur in einer kombinierten Weise verschiedene Lichtquellen (212) emittieren können,
wobei
die Lichtquelle (212) mit einstellbarer Farbtemperatur einen Satz von Leuchtmitteln (2121) mit einer ersten Farbtemperatur und einen Satz von Leuchtmitteln (2122) mit einer zweiten Farbtemperatur aufweist, wobei die Leuchtmittel (2121) mit der ersten Farbtemperatur jeweils an den beiden Seiten der Lichtquelle (211) mit drei Primärfarben angeordnet sind, wobei die Leuchtmittel (2122) mit der zweiten Farbtemperatur an der Außenseite des Leuchtmittels (2121) mit der ersten Farbtemperatur angeordnet sind, so dass die Leuchtmittel mit der ersten Farbtemperatur zwischen der Lichtquelle mit drei Primärfarben und der zweiten Farbtemperatur angeordnet sind,
die Lichtquelle (211) mit drei Primärfarben einen Satz erster Chips (2111) und eine erste Deckschicht (2112) aufweist, wobei die ersten Chips in Längsrichtung angeordnet und entlang einer A-Achse auf dem Substrat (10) ausgerichtet sind, wobei die erste Deckschicht (2112) die Oberfläche der ersten Chips (2111) entlang der A-Achse entsprechend in Längsrichtung bedeckt,
das Leuchtmittel (2121) mit der ersten Farbtemperatur einen Satz zweiter Chips (21211) und eine zweite Deckschicht (21212) aufweist, wobei die zweiten Chips in Längsrichtung angeordnet und entlang der A-Achse ausgerichtet sind, wobei die zweite Deckschicht (21212) die Oberfläche der zweiten Chips (21211) entlang der A-Achse entsprechend in Längsrichtung bedeckt,
das Leuchtmittel (2122) mit der zweiten Farbtemperatur einen Satz dritter Chips (21221) und eine dritte Deckschicht aufweist, wobei die dritten Chips (21221) in Längsrichtung angeordnet und entlang der A-Achse ausgerichtet sind, wobei die dritte Deckschicht die Oberfläche der dritten Chips (21221) entsprechend in Längsrichtung entlang der A-Achse bedeckt,
die zweiten Chips (21211) jeweils an den beiden Seiten der ersten Chips (2111) angeordnet sind, wobei die dritten Chips (21221) an der Außenseite der zweiten Chips (21211) angeordnet sind, so dass die zweiten Chips zwischen den ersten Chips (2111) und den dritten Chips (21221) angeordnet sind,
die Lichtquellenanordnung (20) eine Schaltungskomponente (22) aufweist, die auf dem Substrat (10) angeordnet ist, wobei die Lichtquelle (211) mit drei Primärfarben und die Lichtquelle (212) mit einstellbarer Farbtemperatur jeweils elektrisch mit der Schaltungskomponente (22) verbunden sind, wobei eine externe Energieversorgung über die Schaltungskomponente (22) elektrisch mit der lichtemittierenden Quelle (21) verbunden ist, um es der lichtemittierenden Quelle (21) zu ermöglichen, auf der Grundlage eines vorgegebenen Bedarfs verschiedene Lichtfarben in einer kombinierten Weise zu emittieren, die Schaltungskomponente (22) ein Elektrodenelement und ein elektrisches Verbindungselement aufweist, wobei das Elektrodenelement und das elektrische Verbindungselement jeweils elektrisch mit den ersten Chips (2111), den zweiten Chips (21211) und den dritten Chips (21221) verbunden sind, wobei die externe Energieversorgung es der Lichtquelle (211) mit drei Primärfarben, den Leuchtmitteln (2121) mit der ersten Farbtemperatur und den Leuchtmitteln (2122) mit der zweiten Farbtemperatur über das Elektrodenelement und das elektrische Verbindungselement ermöglicht, in einem aktiven Zustand zum Emittieren von Licht zu sein,
das Elektrodenelement ferner eine Anode (2211) und einen Satz von Kathoden (2212) aufweist, wobei die einen Enden der ersten Chips (2111), der zweiten Chips (21211) und der dritten Chips (21221) gemeinsam elektrisch mit der Anode (2211) verbunden sind, während die anderen Enden der ersten Chips (2111), der zweiten Chips (21211) und der dritten Chips (21221) jeweils elektrisch mit den Kathoden (2212) verbunden sind, wobei die Anode (2211) elektrisch mit der Anode (2211) der externen Energieversorgung verbunden ist, während die Kathoden (2212) elektrisch mit der Kathode der externen Energieversorgung verbunden sind,
der erste Chip ein LED-Chip mit drei Primärfarben ist, der einen Drei-Wege-Chipsatz aus einem Rotlicht-Chip, einem Blaulicht-Chip bzw. einem Grünlicht-Chip aufweist, wobei die erste Deckschicht (2112) ein transparentes Kolloid aus Silikon oder Epoxidharz ist, um zu ermöglichen, dass in einer kombinierten Weise Licht verschiedener Farbe durch die erste Deckschicht (2112) emittiert werden kann, indem das numerische Verhältnis der Spannung und des Stroms des Drei-Wege-Chipsatzes des LED-Chips mit drei Primärfarben eingestellt und konfiguriert wird,
der zweite Chip und der dritte Chip beide Blaulicht-LED-Chips sind, wobei die zweite Deckschicht (21212) ein Kolloid mit einem Bestandteil aus YAG-Phosphor mit einem speziellen Anteil ist, um den zweiten Chips (21211) zu ermöglichen, kühles Licht weißer Farbe mit einer Farbtemperatur von 4500K-7000K durch die zweite Deckschicht (21212) zu emittieren, während die dritte Deckschicht ein Kolloid mit einem Bestandteil aus YAG-Phosphor mit einem anderen bestimmten Anteil ist, um es den dritten Chips (21221) zu ermöglichen, warmes Licht weißer Farbe der Farbtemperatur von 1000K-4500K durch die dritte Deckschicht zu emittieren, so dass es dem Lichtquellenmodul (1) ermöglicht wird, in einer kombinierten Weise weißes Licht der Farbtemperatur von 1000K-7000K durch die zweite Deckschicht (21212) bzw. die dritte Deckschicht und entsprechend zu emittieren, um bei Weißlichtbeleuchtung hinsichtlich der Farbtemperatur einstellbar zu sein.

2. Lampe (2) mit einem Lichtquellenmodul (1), aufweisend:
einen Lampenkörper (30); und
ein Lichtquellenmodul (1) nach Anspruch 1, wobei das Lichtquellenmodul in einer Aufnahmekammer des Lampenkörpers angeordnet ist, wobei das Lichtquellenmodul durch Einstellen oder Ändern der numerischen Werte der Spannung oder des Stroms der externen Energieversorgung in einer kombinierten Weise Licht verschiedener Farbe emittiert.

3. Lampe (2) mit einem Lichtquellenmodul (1) nach Anspruch 2, wobei der Lampenkörper (30) eine Schale (31) aufweist, wobei die Schale (31) ein Gehäuse (312) und eine Linse (314) umfasst, die an dem Gehäuse (312) angeordnet ist, wobei der Lichtstrahl des Lichtquellenmoduls durch die Linse (314) hindurch emittiert wird.

## Revendications

1. Module de source de lumière (1), comprenant :
un substrat (10) ; et
un ensemble source de lumière, comprenant une source d'émission de lumière (21) prévue sur ledit substrat (10),
dans lequel ladite source d'émission de lumière comprend en outre :
une source de lumière à trois couleurs primaires (211), agencée sur ledit substrat (10), et
au moins une source de lumière à température de couleur réglable (212), agencée respectivement sur ledit substrat (10) et à l'extérieur de ladite source de lumière à trois couleurs primaires (211), de manière à permettre à ladite source de lumière à trois couleurs primaires (211) et à ladite source de lumière à température de couleur réglable (212) d'émettre diverses sources de lumière (212) de manière combinée,
dans lequel
ladite source de lumière à température de couleur réglable (212) comprend un jeu de premiers illuminants de température de couleur (2121) et un jeu de deuxièmes illuminants de température de couleur (2122), dans lequel lesdits premiers illuminants de température de couleur (2121) sont respectivement agencés sur les deux côtés de ladite source de lumière à trois couleurs primaires (211), dans lequel lesdits deuxièmes illuminants de température de couleur (2122) sont agencés sur le côté extérieur dudit premier illuminant de température de couleur (2121), de sorte que lesdits premiers illuminants de température de couleur soient situés entre ladite source de lumière à trois couleurs primaires et lesdits deuxièmes illuminants de température de couleur,
ladite source de lumière à trois couleurs primaires (211) comprend un jeu de premières puces (2111) et une première couche de couverture (2112), dans lequel lesdites premières puces sont agencées et alignées longitudinalement le long d'un axe A sur ledit substrat (10), dans lequel ladite première couche de couverture (2112) couvre longitudinalement de manière correspondante la surface desdites premières puces (2111) le long dudit axe A,
ledit premier illuminant de température de couleur (2121) comprend un jeu de deuxièmes puces (21211) et une deuxième couche de couverture (21212), dans lequel lesdites deuxièmes puces sont agencées et alignées longitudinalement le long dudit axe A, dans lequel ladite deuxième couche de couverture (21212) couvre longitudinalement de manière correspondante la surface desdites deuxièmes puces (21211) le long dudit axe A,
ledit deuxième illuminant de température de couleur (2122) comprend un jeu de troisièmes puces (21221) et une troisième couche de couverture, dans lequel lesdites troisièmes puces (21221) sont agencées et alignées longitudinalement le long dudit axe A, dans lequel ladite troisième couche de couverture couvre longitudinalement de manière correspondante la surface desdites troisièmes puces (21221) le long dudit axe A,
lesdites deuxièmes puces (21211) sont agencées respectivement sur les deux côtés desdites premières puces (2111), dans lequel lesdites troisièmes puces (21221) sont agencées sur le côté extérieur desdites deuxièmes puces (21211), de sorte que lesdites deuxièmes puces soient situées entre lesdites premières puces (2111) et lesdites troisièmes puces (21221),
ledit ensemble source de lumière (20) comprend un composant de circuit (22), agencé sur ledit substrat (10), dans lequel ladite source de lumière à trois couleurs primaires (211) et ladite source de lumière à température de couleur réglable (212) sont respectivement connectées électriquement audit composant de circuit (22), dans lequel une alimentation de puissance externe est connectée électriquement à ladite source d'émission de lumière (21) à travers ledit composant de circuit (22), de manière à permettre à ladite source d'émission de lumière (21) d'émettre diverses couleurs de lumière de manière combinée sur la base d'une demande prédéterminée,
ledit composant de circuit (22) comprend un élément d'électrode et un élément de connexion électrique, dans lequel ledit élément d'électrode et ledit élément de connexion électrique sont respectivement connectés électriquement auxdites premières puces (2111), auxdites deuxièmes puces (21211), et auxdites troisièmes puces (21221), dans lequel l'alimentation de puissance externe, à travers ledit élément d'électrode et ledit élément de connexion électrique, permet à ladite source de lumière à trois couleurs primaires (211), auxdits premiers illuminants de température de couleur (2121), et auxdits deuxièmes illuminants de température de couleur (2122) d'être dans un état actif pour émettre de la lumière,
ledit élément d'électrode comprend en outre une anode (2211) et un jeu de cathodes (2212), dans lequel l'une des extrémités desdites premières puces (2111), desdites deuxièmes puces (21211), et desdites troisièmes puces (21221) est mutuellement connectée électriquement à ladite anode (2211), tandis que l'autre des extrémités desdites premières puces (2111), desdites deuxièmes puces (21211), et desdites troisièmes puces (21221) est respectivement connectée électriquement auxdites cathodes (2212), dans lequel ladite anode (2211) est connectée électriquement à l'anode (2211) de l'alimentation de puissance externe, tandis que lesdites cathodes (2212) sont connectées électriquement à la cathode de l'alimentation de puissance externe,
ladite première puce est une puce à LED de trois couleurs primaires, qui comprend un jeu de puces à trois voies d'une puce à lumière rouge, d'une puce à lumière bleue et d'une puce à lumière verte respectivement, dans lequel ladite première couche de couverture (2112) est un colloïde transparent de silicone ou de résine époxy, de manière à permettre à des lumières de diverses couleurs d'être émises de manière combinée à travers ladite première couche de couverture (2112) en réglant et en configurant le rapport numérique de la tension et du courant du jeu de puces à trois voies de la puce à LED de trois couleurs primaires, ladite deuxième puce et ladite troisième puce sont toutes deux des puces à LED à lumière bleue, dans lequel ladite deuxième couche de couverture (21212) est un colloïde avec un ingrédient de phosphore YAG d'une proportion spécifique, de manière à permettre auxdites deuxièmes puces (21211) d'émettre une lumière de couleur blanche à la température de couleur de 4500 K à 7000 K à travers ladite deuxième couche de couverture (21212), tandis que ladite troisième couche de couverture est un colloïde avec un ingrédient de phosphore YAG d'une autre proportion spécifique, de manière à permettre auxdites troisièmes puces (21221) d'émettre une lumière de couleur blanche chaude à la température de couleur de 1000 K à 4500 K à travers ladite troisième couche de couverture, de sorte que ledit module de source de lumière (1) ait la possibilité d'émettre une lumière blanche à la température de couleur de 1000 K à 7000 K de manière combinée à travers ladite deuxième couche de couverture (21212) et ladite troisième couche de couverture respectivement et de manière correspondante, de sorte à avoir une température de couleur réglable dans l'éclairage en lumière blanche.

2. Lampe (2) avec un module de source de lumière (1), comprenant
un corps de lampe (30) ; et
un module de source de lumière (1) selon la revendication 1, dans laquelle ledit module de source de lumière est agencé dans une chambre de réception dudit corps de lampe, dans laquelle ledit module de source de lumière émet une lumière de diverses couleurs de manière combinée en réglant ou en changeant les valeurs numériques de la tension ou du courant de l'alimentation de puissance externe.

3. Lampe (2) avec un module de source de lumière (1), selon la revendication 2,
dans laquelle ledit corps de lampe (30) comprend une coque (31), dans laquelle ladite coque (31) comprend un boîtier (312) et une lentille (314) agencée sur ledit boîtier (312), dans laquelle le faisceau de lumière dudit module de source de lumière est émis à travers ladite lentille (314).
